# EUROPEAN PATENT SPECIFICATION

(11) **EP 4 542 238 B1**
(45) Date of publication and mention of the grant of the patent: **22.04.2026**
(21) Application number: 23306828.7
(22) Date of filing: 18.10.2023
(51) Int. Cl.: G01R 31/08, G01R 31/11, G01R 31/58

(54) **FAULT LOCATION ON LONG SUBMARINE CABLES, PINPOINTING ON LONG CABLES**
FEHLERLOKALISIERUNG AUF LANGEN UNTERWASSERKABELN, ORTUNG AUF LANGEN KABELN
LOCALISATION DE DÉFAUT SUR DES CÂBLES SOUS-MARINS LONGS, REPÉRAGE SUR DES CÂBLES LONGS

(43) Date of publication of application: 23.04.2025
(73) Proprietor: Nexans, 92400 Courbevoie (FR)
(72) Inventor: CLASEN, Geir, 1781 HALDEN (NO)
(74) Representative: Acapo Onsagers AS

(56) References cited:
- CN-A- 109 884 444
- JP-A- 2001 183 410
- US-A- 5 608 328
- BAWART MANFRED ET AL: "Diagnosis and location of faults in submarine power cables", IEEE ELECTRICAL INSULATION MAGAZINE, IEEE, USA, vol. 32, no. 4, 1 July 2016 (2016-07-01), pages 24 - 37, XP011618300, ISSN: 0883-7554, [retrieved on 20160801], DOI: 10.1109/MEI.2016.7528987

## Description

### FIELD OF THE INVENTION

The present invention relates to a fault location system for localization of a fault in a submarine power cable. The present invention also relates to a method for localization of a fault in a submarine power cable.

### BACKGROUND

Several methods are known to find a fault location on submarine power cables.

A time-domain reflectometer (abbreviated TDR) is an electronic instrument used to determine the characteristics of electrical lines by observing reflected pulses sent into the conductor of the power cable. The TDR generates a pulse with an amplitude of a few hundred volts and is only suitable to detect faults if there is a complete breakdown of the insulation in the cable. There is also limitation in how far into the cable the fault may be, today the maximum seems to be about 700 km with the upgraded instruments.

It is also known to incorporate a fibre optic cable, typically in the form of a FIMT (Fibre In Metallic Tube) into the submarine power cable to detect mechanical deformation of the cable. There may be mechanical deformations which do not cause faults. However, if there is a fault somewhere in the cable, the location of a (larger) mechanical deformation will typically be the fault location.

A fibre optic cable as above may also be used to detect a sound, such as the sound of a short-circuit current through an insulation layer of the power cable. A system for detecting such sounds is often referred to as a distributed acoustic sensing system (abbreviated DAS).

The above methods do not work satisfying for long submarine cables, i.e. for cables longer than 200 km, as it becomes impossible to identify the correct electrical/optical/acoustic signal from noise.

Typically, faults in such submarine power cables are caused by mechanical damage caused by a ship anchor, a ship trawl etc. Consequently, the fault location on such long power cables is found by analyzing ship traffic by means of AIS data (Automatic Identification System) in order to identify where ships passed on or near the cable at the time the fault was detected. Hopefully, only a few suspected ships are found. Then, a ROV (Remotely Operated Vehicle) is used to visually inspect the sections of the cable over which ships has passed in order to find the fault. As some cables are buried into the seabed, un-trenching of the cable may be necessary.

The document ,BAWART MANFRED ET AL: "Diagnosis and location of faults in submarine power cables",IEEE ELECTRICAL INSULATION MAGAZINE, IEEE, USA, vol. 32, no. 4, 1 July 2016 (2016-07-01), pages 24-37, discloses a method for locating faults in submarine cables. A HV DC generator charges a capacitor which is then discharged to provide a power surge to the submarine cable being tested.

One object of the present invention is to improve the accuracy and/or the efficiency of fault location in submarine power cables.

### SUMMARY OF THE INVENTION

The present invention relates to a fault location system for localization of a fault in a submarine power cable, wherein the fault location system comprises:
- a pulse generating device for generating an electric pulse signal;
- a signal analyzing device configured to determine the localization of the fault by analyzing a reflection signal resulting from the electric pulse signal being reflected from the submarine power cable;

wherein the pulse generating device comprises a signal generator, a first output terminal and a second output terminal, wherein the first output terminal is connectable to a conductor of the submarine power cable and wherein the second terminal is connectable to a screen of the submarine power cable;
wherein
   - the signal generator is a HV DC generator;
wherein the pulse generating device further comprises:
   - a power cable connected between the signal generator and one of the output terminals;
   - a switch;
   - a control circuit for controlling the switch;
wherein the power cable has a first end and a second end and comprises a conductor, an insulating system outside of the conductor and a screen outside of the insulating system;
wherein the HV DC generator is connected between the conductor of the first end of the power cable and the screen of the power cable;
wherein the conductor of the second end of the power cable is connected to the first output terminal;
wherein the screen of the power cable is connected to the second output terminal;
wherein the control circuit is configured to:
   - turn the switch off in order to charge the power cable with power from the HV DC generator;
   - turn the switch on in order to discharge the power of the power cable into the submarine power cable.

The first output terminal may be connectable to the conductor of the submarine power cable via the signal analyzing device. The second terminal may be connectable to the screen of the submarine power cable via the signal analyzing devi ce

The HV DC generator may be connected between the conductor of the first end of the power cable and the screen of the first end of the power cable.

The screen of the first end of the power cable may be connected to the second output terminal. The screen of the second end of the power cable may be connected to the second output terminal.

The pulse generating device may be referred to as a pulse forming line.

The control circuit may be configured to turn the switch on after the power cable has been charged with power from the HV DC generator.

The power cable may be a medium voltage AC or DC cable or may be a high voltage AC or DC cable; and/or may have a length of 50 - 150 m. The power cable may have a nominal voltage of 3 kV - 100 kV.

The power cable may be wound into a coil. The power cable may be wound onto an elongated object, such as a cylindrical object, a drum etc. Alternatively, the power cable may be laid out on the ground.

The switch may be connected between the conductor of the second end of the power cable and the first output terminal.

When the switch is off, the power cable is charged by the HV DC generator. Hence, there is a voltage potential stored between the conductor of the power cable and the screen of the power cable. When the switch is turned on, a pulse is formed by the voltage potential stored in the power cable and this pulse is allowed to enter into the submarine power cable.

The pulse generated by the pulse generating device may be sufficiently large to create a so-called flashover at the fault of the submarine power cable. A flashover is here an intended electrical discharge at the fault of the of the submarine power cable.

The pulse generating device may comprise:
- a further power cable connected between the signal generator and one of the output terminals;

wherein the further power cable has a first end and a second end and comprises a conductor, an insulating system outside of the conductor and a screen outside of the insulating system;
wherein the conductor of the further power cable is connected to the conductor of the second end of the power cable;
wherein the screen of the further power cable is be connected to the first output terminal.

The switch may be connected between the conductor of the first end of the power cable and the screen of the first end of the power cable.

The further power cable may be a medium voltage AC or DC cable or may be a high voltage AC or DC cable; and/or may have a length of 50 - 150 m. The further power cable may have a nominal voltage of 3 kV - 100 kV.

Also the further power cable may be wound into a coil. The further power cable may be wound onto an elongated object, such as a cylindrical object, a drum etc. The elongated object for the further power cable may be the same object as for the power cable. The elongated object for the further power cable may be an object separate from the object for the power cable.

According to the above, the switch may be connected indirectly to the second end of the conductor of the power cable.

The signal analyzing device may comprise a high voltage divider.

The switch may be high voltage switch. The switch may be a spark-gap type of switch. The switch may be a gas/vacuum insulated switch. The switch may be a fluid insulated switch.

The HV DC generator may supply a nominal DC voltage of ca 3 kV - 100 kV.

The signal analyzing device may be configured to determine the localization of the fault as a first fault section of the submarine power cable.

The first fault section may be defined with a first distance from a termination of the submarine power cable. The first fault section may be defined with a first length. The first length may represent a margin of error of the location of the fault.

According to the above, the pulse generating device of the fault location system may generate a pulse having an amplitude from 50 - 500 kV, preferably from 200 - 300 kV. This will be sufficient to cause a flashover at a fault location in a submarine power cable having a nominal voltage of up to 600 - 700 kV having a length of more than 200 km, which then can be detected with the signal analyzing device.

The fault location system may comprise:
- a fibre optic cable configured to be located along the first fault section of the submarine power cable;
- an optic signal generator for sending an optic signal into the fibre optic cable;
- a optic signal analyzing device for analyzing an optic reflection signal resulting from the optic signal being reflected from the fibre optic cable during a period in which an electric pulse signal is generated by the pulse generating device;
wherein the optic signal analyzing device is configured to determine the location of the fault as a second fault section of the submarine power cable.

As the pulse generating device will create a flashover at the fault location, a sound will be created. The sound will be detectable by the optic signal analyzing device.

The second fault section is a subsection of the first fault section. Hence, the second fault section has a second length being smaller than the first length.

The first fault section will typically be much shorter than the length of the submarine power cable. Hence, the length of the fibre optic cable may be much shorter than the length of the submarine power cable. Hence, the fault may be found with relatively high accuracy by means of the fibre optic cable, the optic signal generator and the optic signal analyzing device.

The insulating system may comprise an inner semiconducting layer, an insulating layer outside of the inner semiconducting layer, and an outer semiconducting layer outside of the insulating layer.

The present invention also relates to a method for localization of a fault in a submarine power cable, wherein the method comprises the steps of:
- charging a power cable with power from an HV DC generator;
- discharging the power of the power cable as an electric pulse signal into the submarine power cable;
- determining the localization of the fault by analyzing a reflection signal resulting from the electric pulse signal being reflected from the submarine power cable.

The step of determining the localization of the fault may comprise determining the localization of the fault as a first fault section of the submarine power cable.

The method further may comprise the step of:
- locating a fibre optic cable along the first fault section of the submarine power cable;
- sending an optic signal into the fibre optic cable;
- determining the location of the fault as a second fault section of the submarine power cable by analyzing an optic reflection signal resulting from the optic signal may be reflected from the fibre optic cable during a period in which an electric pulse signal may be discharged from the power cable.

### LIST OF DRAWINGS

Fig. 1 illustrates a first part of a fault location system for fault location on a submarine cable;
Fig. 2 illustrates a pulse generating device of the fault location system of fig. 1;
Fig. 3 illustrates an example of a pulse generated by the fault location system of fig. 1;
Fig. 4 illustrates the location of the fault by using the first part of the fault location system;
Fig. 5 illustrates a second part of the fault location system;
Fig. 6 illustrates the location of the fault by using the second part of the fault location system;
Fig. 7 illustrates the cable being repaired;
Fig. 8 illustrates a second embodiment of the pulse generating device.

### DETAILED DESCRIPTION

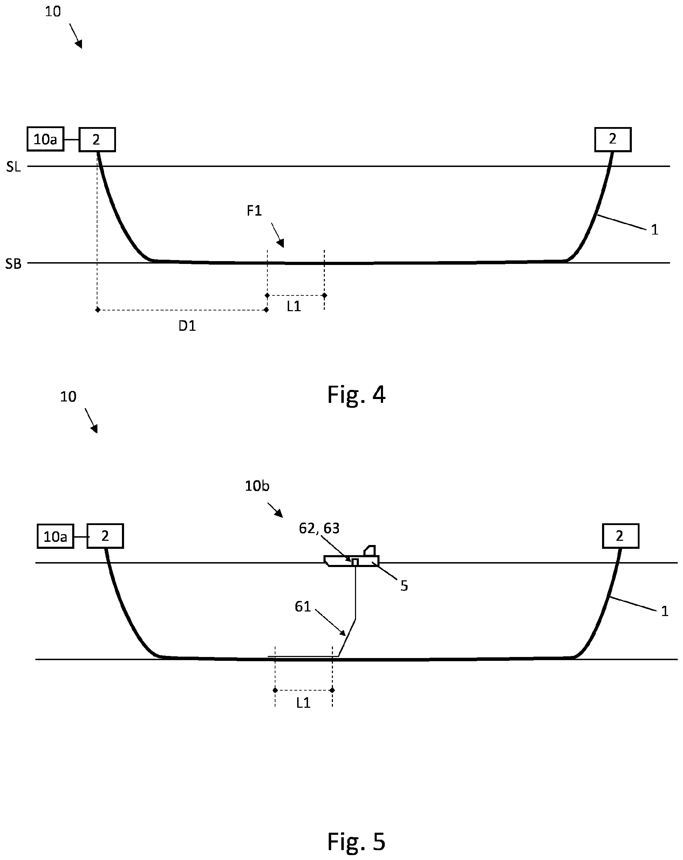

Initially, it is referred to fig. 4, where a submarine power cable 1 is shown schematically. Most of the submarine power cable 1 is located on top of or at least partially buried within a seabed SB. Each end of the submarine power cable 1 is terminated at respective terminations 2 above a sea level SL. In the present embodiment, the submarine power cable 1 has a nominal voltage of 320 kV and a length of more than 200 km.

The submarine power cable 1 has a fault somewhere along the submarine power cable 1. This fault may for example be caused by an anchor or a trawl of a vessel passing above the submarine power cable 1.

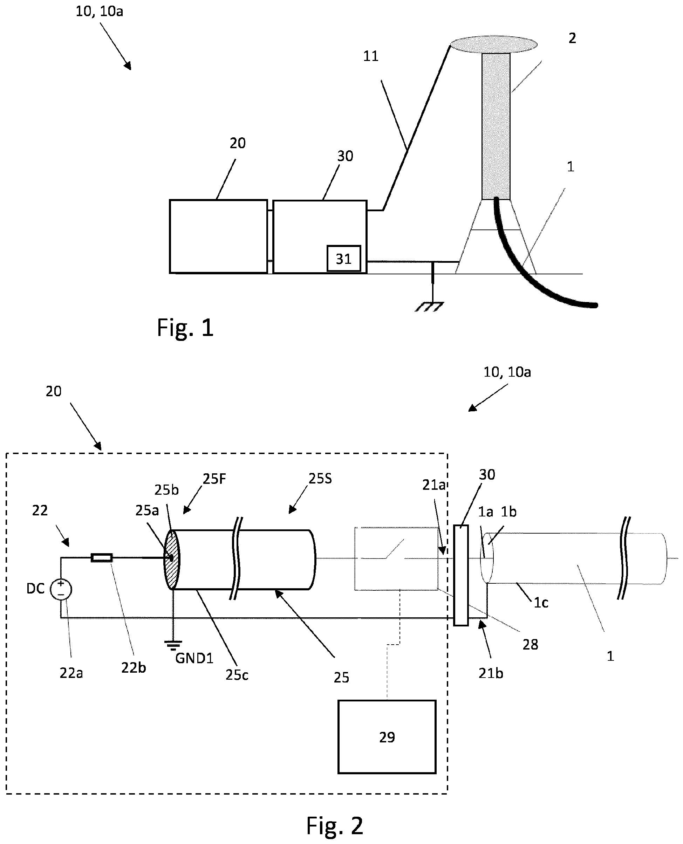

In fig. 1, a fault location system 10 for localization of the fault in the submarine power cable 1 is shown. As is well known, the submarine power cable 1 comprises at least a conductor 1a, an insulating system 1b outside of the conductor 1a and a screen 1c outside of the insulating system 1b (as indicated in fig. 2). The insulating system typically comprises an inner semiconducting layer, an insulating layer outside of the inner semiconducting layer and an outer semiconducting layer outside of the insulating layer.

As will be apparent from the description below, the fault location system 10 preferably comprises two subsystems referred to as a first subsystem 10a and a second subsystem 10b, where fig. 1 is showing the first subsystem 10a.

The first subsystem 10a comprises a pulse generating device 20, and a signal analyzing device 30 connected to one of the ends of the fault location system 10, i.e. at one of the terminations 2. The pulse generating device 20 is generating an electric pulse which is sent into the submarine power cable 1. The signal analyzing device 30 is configured to determine the location of the fault by analyzing a reflection signal resulting from the electric pulse signal being reflected from the submarine power cable 1. The operation of analyzing the reflection signal comprises comparing the signal being sent into the submarine power cable 1 from the pulse generating device with the reflection signal, including analysing the time from sending the signal into the cable 1 to receiving the reflection signal.

In the present embodiment, the signal analyzing device 30 is a commercially available time-domain reflectometer. In the present embodiment, the signal analyzing device 30 is a low-voltage time-domain reflectometer. Here, the time-domain reflectometer comprises an additional high voltage divider 31 in order to transform the reflected signal to a suitable voltage level for the time-domain reflectometer.

### First embodiment of pulse generating device 20 of the first subsystem 10a

It is now referred to fig. 2, where a first embodiment of the pulse generating device is shown within the dashed box indicated as 20 having two output terminals 21 in the form of a first output terminal 21a and a second output terminal 21b. The pulse generating device 20 comprises a signal generator 22 connected to the output terminals 21 via a power cable 25 and a switch 28.

The signal generator 22 is a HV (high voltage) DC (direct current) signal generator which in fig. 2 is electrically represented as a DC voltage source 22a and a resistor 22b. The signal generator 22 is supplying a nominal DC voltage of ca 3 kV - 100 kV. Normal voltage range for which this system is meant to operate would be 20 kV - 100 kV.

The power cable 25 is defined with a first end 25F and a second end 25S and comprises a conductor 25a, an insulating system 25b outside of the conductor 25a and a screen 25c outside of the insulating system 25b. The power cable 25 is a MV (medium voltage) power cable or a HV (high voltage) power cable, i.e. with a nominal voltage of 3 kV - 100 kV. The power cable 25 It should be noted that above 3kV, the power cable 25 may be a DC cable or an AC cable. The length of the power cable 25 is in the present embodiment between 50 - 150 m. The power cable 25 must be able to withstand the voltages for which the intended operation of the system.

In order to save space, the power cable 25 is wound into a coil onto a drum.

The switch 28 is in the present embodiment a high voltage spark-gap type of switch. In fig. 2, it is further shown that the pulse generating device 20 comprises a control circuit 29 for controlling the switch 28.

As shown in fig. 2, a negative terminal of the signal generator 22, which here corresponds to the second output terminal 21b, is connected to the screen 1c of the submarine power cable 1 via the signal analyzing device 30. This is indicated as ground GND1. Also the screen 25c of the power cable 25 is connected to ground GND1. The positive terminal of the signal generator 22 is connected to the conductor 25a of the first end 25F of the power cable 25. The conductor 25a of the second end 25S of the power cable 25 is connected to the first output terminal 21a via the switch 28. The first output terminal 21a is connected to the conductor 1a of the submarine power cable 1 via the signal analyzing device 30.

The first embodiment of the pulse generating device 20 may be referred to as pulse forming line.

### Second embodiment of pulse generating device 20 of the first subsystem 10a

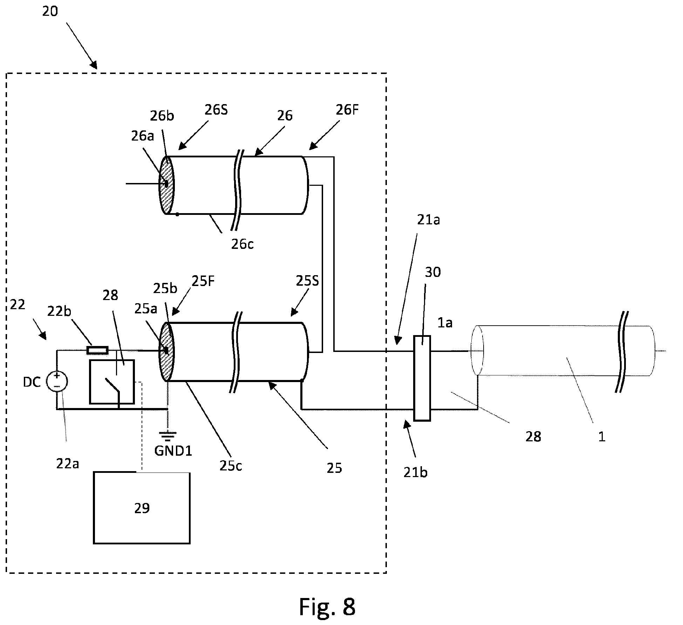

It is now referred to fig. 8. The signal generator 22, the power cable 25, the switch 28 and the control circuit 29 for the switch 28 is here identical to the first embodiment and will therefore not be described here in detail.

The second embodiment of the pulse generating device 20 comprises a further power cable 26 defined with a first end 26F and a second end 26S and comprises a conductor 26a, an insulating system 26b outside of the conductor 26a and a screen 26c outside of the insulating system 26b. The further power cable 26 has the same properties as the power cable 25 and is wound into a coil onto the same drum as the power cable 25 in order to save space.

In the second embodiment, the negative terminal of the signal generator 22 is connected to the screen 25c of the first end 25F of the power cable 25 (indicated as ground GND1 in fig. 8). The screen 25c of the second end 25S of the power cable 25 is connected to the screen 1c of the submarine power cable 1 via the signal analyzing device 30. The positive terminal of the signal generator 22 is connected to the conductor 25a of the first end 25F of the power cable 25, similar to the first embodiment.

In the second embodiment, the switch 28 is connected between the negative terminal of the signal generator 22 (i.e. ground GND1) and the conductor 25a of the first end 25F of the power cable 25.

The conductor 25a of the first end 25F of the power cable 25 is connected to the conductor 26a of the first end 26F of the further power cable 26. In this embodiment, the conductor 26a at the second end 26S of the further power cable 26 is not connected further.

The screen 26c of the first end 26F of the further power cable 26 is connected to the conductor 1a of the submarine power cable 1 via the signal analyzing device 30.

As the second embodiment has more than one power cable, the second embodiment of the pulse generating device 20 may be referred to as pulse forming network.

It should be noted that the one or more further power cables (not shown) may be connected to the further power cable 26.

### Operation of the first subsystem 10a

The operation of the above embodiments of the first subsystem 10a will now be described.

Initially, it should be noted that the first subsystem 10a will be connected to the submarine power cable 1 after a fault has been detected.

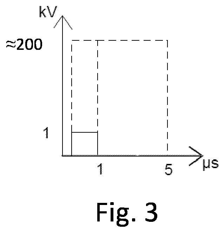

First, the switch 28 is controlled to be off for a predetermined period of time, in order for the signal generator 22 to charge the power cable 25 of fig. 2 or to charge the power cable 25 and the further power cable 26 of fig. 8. Typically, this will take 5 - 10 seconds. Then, the switch 28 is controlled to be on. This will cause the charged cable to output an electric pulse as indicated schematically in fig. 3, having an amplitude of up to 200 - 300 kV and a duration of 1-5 microseconds. This electric pulse will propagate into the submarine power cable 1. At the location of the fault, the pulse will create a so-called flashover due to the damaged insulating system at the location of the fault.

The pulse sent into the submarine power cable 1 will be reflected back and registered by the signal analyzing device 30. By analyzing the reflected signal received by the signal analyzing device 30, it is possible to determine the localization of the fault as a first fault section F1 of the submarine power cable 1, as indicated in fig. 4. The first fault section F1 is here defined as a first distance D1 from the termination 2 of the submarine power cable 1 at which the first subsystem 10a is located. The first fault section F1 is further defined with a first length L1 representing a margin of error of the location of the fault. The length L1 would be determined by the accuracy of the signal analyzing device 30. Typically, this accuracy will be 1% of the complete length of the submarine power cable 1. Consequently, for a 500 km length of submarine power cable 1, the length L1 would be ca 5 km.

The first subsystem 10a may send several pulses into the submarine power cable 1 and analyze the reflected signal from each of these pulses in order to more precisely determine the location of the fault.

### The second subsystem 10b

In order to further localize the fault of the submarine power cable 1, the second subsystem 10b is used after the first subsystem 10a has been used.

It is now referred to fig. 5. Here it is shown that the second subsystem 10b of the fault location system 10 comprises a fibre optic cable 61 deployed along the first fault section F1 of the submarine power cable 1. The fibre optic cable 61 will typically be deployed from a vessel 5. Hence, one end of the fibre optic cable 61 will be provided onboard of the vessel 5. The second subsystem 10b further comprises an optic signal generator 62 for sending an optic signal into the fibre optic cable 61 and an optic signal analyzing device 63 for analyzing an optic reflection signal resulting from the optic signal being reflected from the fibre optic cable 61.

The first subsystem 10a is again generating an electric pulse and sending the pulse into the submarine power cable 1. Again, a flashover will be created at the fault location, which will create a sound. This sound is will cause a movement of the fibre optic cable 61. The location of such a movement is detectable by the optic signal analyzing device 63 when analyzing the optic reflection signal resulting from the optic signal being reflected from the fibre optic cable 61 during the flashover.

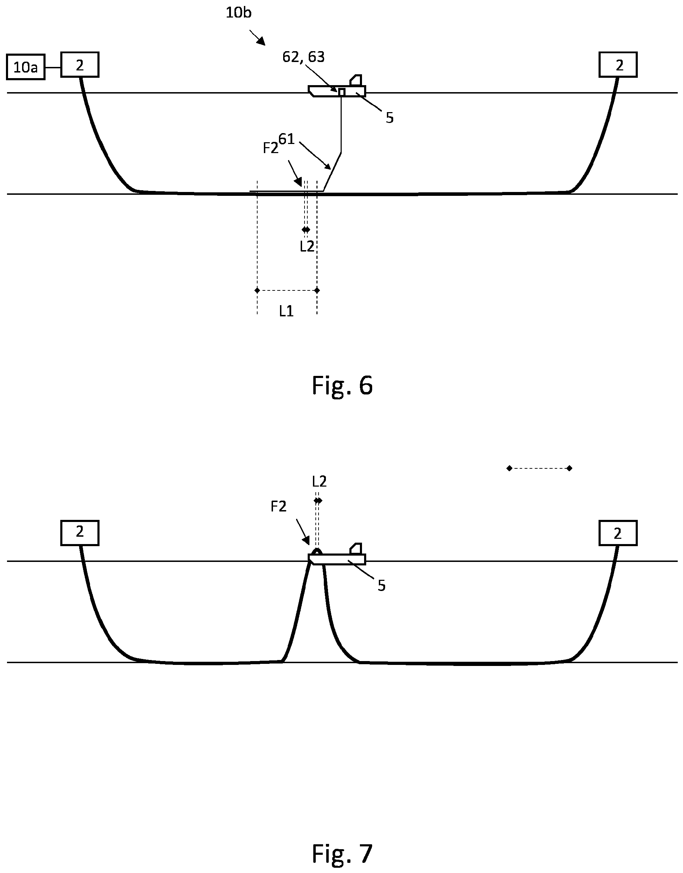

It is now referred to fig. 6. Here it is shown that the optic signal analyzing device 63 is determining the location of the fault as a second fault section F2 of the submarine power cable 1. The second fault section F2 will be a subsection of the first fault section F1 and have a second length L2 being much shorter than the first length L1.

In fig. 7, it is shown that the second fault section F2 has been elevated up to the vessel 5 for repair, typically by cutting the submarine power cable 1 on each side of the second fault section F2 of the submarine power cable 1, then removing the second fault section F2 and finally jointing a replacement section between the two cuts.

It should be noted that in the above description, the voltage generated by the signal generator 22 may be higher than the nominal voltage of the power cable 25 and/or the further power cable 26, as the power cable 25 and the further power cable 26 only are used for a very short period of time. Should the power cable 25 and the further power cable 26 be damaged or deteriorated, it is relatively simple to replace them.

### LIST OF REFERENCE NUMBERS

- 1: submarine power cable
- 1a: conductor
- 1c: screen
- 2: termination
- 10: fault location system
- 20: pulse generating device
- 21a: first output terminal
- 21b: second output terminal
- 22: HV DC generator
- 25: power cable
- 25F: first end of power cable 25
- 25S: second end of power cable 25
- 25a: conductor of power cable 25
- 25b: insulating system of power cable 25
- 25c: screen of power cable 25
- 26: further power cable
- 26F: first end of further power cable 26
- 26S: second end of further power cable 26
- 26a: conductor of further power cable 26
- 26b: insulating system of further power cable 26
- 26c: screen of further power cable 26
- 28: switch
- 29: control circuit
- 30: signal analyzing device
- 31: high voltage divider
- 61: fibre optic cable
- 62: optic signal generator
- 63: optic signal analyzing device
- D1: first distance
- F1: first fault section
- F2: second fault section
- L1: first length
- L2: second length

## Claims

1. A fault location system (10) for localization of a fault in a submarine power cable (1), wherein the fault location system (10) comprises:
- a pulse generating device (20) for generating an electric pulse signal;
- a signal analyzing device (30) configured to determine the localization of the fault by analyzing a reflection signal resulting from the electric pulse signal being reflected from the submarine power cable (1);
wherein the pulse generating device (20) comprises a signal generator (22), a first output terminal (21a) and a second output terminal (21b), wherein the first output terminal (21a) is connectable to a conductor (1a) of the submarine power cable (1) and wherein the second terminal (21b) is connectable to a screen (1c) of the submarine power cable (1);
wherein:
- the signal generator (22) is a HV DC generator (22);
**characterised in that**:
the pulse generating device (20) further comprises:
- a power cable (25) connected between the signal generator (22) and one of the output terminals (21a, 21b);
- a switch (28);
- a control circuit (29) for controlling the switch (28);
wherein the power cable (25) has a first end (25F) and a second end (25S) and comprises a conductor (25a), an insulating system (25b) outside of the conductor (25a) and a screen (25c) outside of the insulating system (25b);
wherein the HV DC generator (22) is connected between the conductor (25a) of the first end (25F) of the power cable (25) and the screen (25c) of the power cable (25); wherein the conductor (25a) of the second end (25S) of the power cable (25) is connected to the first output terminal (21a);
wherein the screen (25c) of the power cable (25) is connected to the second output terminal (21b);
wherein the control circuit (29) is configured to:
- turn the switch (28) off in order to charge the power cable (25) with power from the HV DC generator (22);
- turn the switch (28) on in order to discharge the power of the power cable (25) into the submarine power cable (1).

2. The fault location system (10) according to claim 1, wherein the HV DC generator (22) is connected between the conductor (25a) of the first end (25F) of the power cable (25) and the screen (25c) of the first end (25F) of the power cable (25).

3. The fault location system (10) according to claim 1 or 2, wherein the screen (25c) of the first end (25F) of the power cable (25) is connected to the second output terminal (21b) and/or wherein the screen (25c) of the second end (25S) of the power cable (25) is connected to the second output terminal (21b).

4. The fault location system (10) according to any one of the above claims, wherein the control circuit (29) is configured to turn the switch (28) on after the power cable (25) has been charged with power from the HV DC generator (22).

5. The fault location system (10) according to any one of the above claims, wherein the power cable (25):
- is a medium voltage AC or DC cable or is a high voltage AC or DC cable; and/or
- has a length of 50 - 150 m.

6. The fault location system (10) according to any one of the above claims, wherein the power cable (25) is wound into a coil.

7. The fault location system (10) according to any one of the above claims, wherein the switch (28) is connected between the conductor (25a) of the second end (25S) of the power cable (25) and the first output terminal (21a).

8. The fault location system (10) according to any one of the above claim 1 - 6, wherein the pulse generating device (20) comprises:
- a further power cable (26) connected between the signal generator (22) and one of the output terminals (21a, 21b);
wherein the further power cable (26) has a first end (26F) and a second end (26S) and comprises a conductor (26a), an insulating system (26b) outside of the conductor (26a) and a screen (26c) outside of the insulating system (26b);
wherein the conductor (26a) of the further power cable (26) is connected to the conductor (25a) of the second end (25S) of the power cable (25);
wherein the screen (26c) of the further power cable (26) is connected to the first output terminal (21a).

9. The fault location system (10) according to claim 8, wherein the switch (28) is connected between the conductor (25) of the first end (25F) of the power cable (25) and the screen (25c) of the first end (25F) of the power cable (25).

10. The fault location system (10) according to claim 8 or 9, wherein the further power cable (26):
- is a medium voltage AC or DC cable or is a high voltage AC or DC cable; and/or
- has a length of 50 - 150 m.

11. The fault location system (10) according to any one of the above claims,
wherein the signal analyzing device (30) comprises a high voltage divider (31).

12. The fault location system (10) according to any one of the above claims,
wherein the signal analyzing device (30) is configured to determine the localization of the fault as a first fault section (F1) of the submarine power cable (1).

13. The fault location system (10) according to claim 12, wherein the fault location system (10) further comprises:
- a fibre optic cable (61) configured to be located along the first fault section (F1) of the submarine power cable (1);
- an optic signal generator (62) for sending an optic signal into the fibre optic cable (61);
- a optic signal analyzing device (63) for analyzing an optic reflection signal resulting from the optic signal being reflected from the fibre optic cable (61) during a period in which an electric pulse signal is generated by the pulse generating device (20);
wherein the optic signal analyzing device (63) is configured to determine the location of the fault as a second fault section (F2) of the submarine power cable (1).

14. A method for localization of a fault in a submarine power cable (1), wherein the method comprises the steps of:
- charging a power cable (25) with power from an HV DC generator (22);
- discharging the power of the power cable (25) as an electric pulse signal into the submarine power cable (1);
- determining the localization of the fault by analyzing a reflection signal resulting from the electric pulse signal being reflected from the submarine power cable (1).

15. The method according to claim 14, wherein the step of determining the localization of the fault comprises determining the localization of the fault as a first fault section (F1) of the submarine power cable (1).

16. The method according to claim 15, wherein the method further comprises the step of:
- locating a fibre optic cable (61) along the first fault section (F1) of the submarine power cable (1);
- sending an optic signal into the fibre optic cable (61);
- determining the location of the fault as a second fault section (F2) of the submarine power cable (1) by analyzing an optic reflection signal resulting from the optic signal being reflected from the fibre optic cable (61) during a period in which an electric pulse signal is discharged from the power cable (25).

## Patentansprüche

1. Fehlerlokalisierungssystem (10) zur Lokalisierung eines Fehlers in einem Unterwasserstromkabel (1),
wobei das Fehlerlokalisierungssystem (10) Folgendes umfasst:
- eine Impulserzeugungsvorrichtung (20) zum Erzeugen eines elektrischen Impulssignals;
- eine Signalanalysevorrichtung (30), die dazu konfiguriert ist, die Lokalisierung des Fehlers durch Analysieren eines Reflexionssignals zu bestimmen, das sich aus dem elektrischen Impulssignal ergibt, das von dem Unterwasserstromkabel (1) reflektiert wird;
wobei die Impulserzeugungsvorrichtung (20) einen Signalgenerator (22), einen ersten Ausgangsanschluss (21a) und einen zweiten Ausgangsanschluss (21b) umfasst, wobei der erste Ausgangsanschluss (21a) mit einem Leiter (1a) des Unterwasserstromkabels (1) verbindbar ist und wobei der zweite Anschluss (21b) mit einer Abschirmung (1c) des Unterwasserstromkabels (1) verbindbar ist;
wobei:
- der Signalgenerator (22) ein Hochspannungs-Gleichstrom-Generator (22) ist;
**dadurch gekennzeichnet, dass**:
die Impulserzeugungsvorrichtung (20) ferner Folgendes umfasst:
- ein Stromkabel (25), das zwischen dem Signalgenerator (22) und einem der Ausgangsanschlüsse (21a, 21b) angeschlossen ist;
- einen Schalter (28);
- eine Steuerschaltung (29) zum Steuern des Schalters (28);
wobei das Stromkabel (25) ein erstes Ende (25F) und ein zweites Ende (25S) aufweist und einen Leiter (25a), ein isolierendes System (25b) außerhalb des Leiters (25a) und eine Abschirmung (25c) außerhalb des isolierenden Systems (25b) umfasst;
wobei der Hochspannungs-Gleichstrom-Generator (22) zwischen dem Leiter (25a) des ersten Endes (25F) des Stromkabels (25) und der Abschirmung (25c) des Stromkabels (25) angeschlossen ist; wobei der Leiter (25a) des zweiten Endes (25S) des Stromkabels (25) mit dem ersten Ausgangsanschluss (21a) verbunden ist;
wobei die Abschirmung (25c) des Stromkabels (25) mit dem zweiten Ausgangsanschluss (21b) verbunden ist;
wobei die Steuerschaltung (29) für Folgendes konfiguriert ist:
- Ausschalten des Schalters (28), um das Stromkabel (25) mit Strom aus dem Hochspannungs-Gleichstrom-Generator (22) zu laden;
- Einschalten des Schalters (28), um den Strom des Stromkabels (25) in das Unterwasserstromkabel (1) zu entladen.

2. Fehlerlokalisierungssystem (10) nach Anspruch 1, wobei der Hochspannungs-Gleichstrom-Generator (22) zwischen dem Leiter (25a) des ersten Endes (25F) des Stromkabels (25) und der Abschirmung (25c) des ersten Endes (25F) des Stromkabels (25) angeschlossen ist.

3. Fehlerlokalisierungssystem (10) nach Anspruch 1 oder 2, wobei die Abschirmung (25c) des ersten Endes (25F) des Stromkabels (25) mit dem zweiten Ausgangsanschluss (21b) verbunden ist und/oder wobei die Abschirmung (25c) des zweiten Endes (25S) des Stromkabels (25) mit dem zweiten Ausgangsanschluss (21b) verbunden ist.

4. Fehlerlokalisierungssystem (10) nach einem der vorhergehenden Ansprüche, wobei die Steuerschaltung (29) dazu konfiguriert ist, den Schalter (28) einzuschalten, nachdem das Stromkabel (25) mit Strom aus dem Hochspannungs-Gleichstrom-Generator (22) geladen worden ist.

5. Fehlerlokalisierungssystem (10) nach einem der vorhergehenden Ansprüche, wobei das Stromkabel (25):
- ein Mittelspannungs-Wechselstrom- oder -Gleichstromkabel oder ein Hochspannungs-Wechselstrom- oder -Gleichstromkabel ist; und/oder - eine Länge von 50 bis 150 m aufweist.

6. Fehlerlokalisierungssystem (10) nach einem der vorhergehenden Ansprüche, wobei das Stromkabel (25) zu einer Spule gewickelt ist.

7. Fehlerlokalisierungssystem (10) nach einem der vorhergehenden Ansprüche, wobei der Schalter (28) zwischen dem Leiter (25a) des zweiten Endes (25S) des Stromkabels (25) und dem ersten Ausgangsanschluss (21a) angeschlossen ist.

8. Fehlerlokalisierungssystem (10) nach einem der vorhergehenden Ansprüche 1 bis 6, wobei die Impulserzeugungsvorrichtung (20) Folgendes umfasst:
- ein weiteres Stromkabel (26), das zwischen dem Signalgenerator (22) und einem der Ausgangsanschlüsse (21a, 21b) angeschlossen ist;
wobei das weitere Stromkabel (26) ein erstes Ende (26F) und ein zweites Ende (26S) aufweist und einen Leiter (26a), ein isolierendes System (26b) außerhalb des Leiters (26a) und eine Abschirmung (26c) außerhalb des isolierenden Systems (26b) umfasst;
wobei der Leiter (26a) des weiteren Stromkabels (26) mit dem Leiter (25a) des zweiten Endes (25S) des Stromkabels (25) verbunden ist;
wobei die Abschirmung (26c) des weiteren Stromkabels (26) mit dem ersten Ausgangsanschluss (21a) verbunden ist.

9. Fehlerlokalisierungssystem (10) nach Anspruch 8, wobei der Schalter (28) zwischen dem Leiter (25) des ersten Endes (25F) des Stromkabels (25) und der Abschirmung (25c) des ersten Endes (25F) des Stromkabels (25) angeschlossen ist.

10. Fehlerlokalisierungssystem (10) nach Anspruch 8 oder 9, wobei das weitere Stromkabel (26):
- ein Mittelspannungs-Wechselstrom- oder -Gleichstromkabel oder ein Hochspannungs-Wechselstrom- oder -Gleichstromkabel ist; und/oder - eine Länge von 50 bis 150 m aufweist.

11. Fehlerlokalisierungssystem (10) nach einem der vorhergehenden Ansprüche, wobei die Signalanalysevorrichtung (30) einen Hochspannungsteiler (31) umfasst.

12. Fehlerlokalisierungssystem (10) nach einem der vorhergehenden Ansprüche, wobei die Signalanalysevorrichtung (30) dazu konfiguriert ist, die Lokalisierung des Fehlers als einen ersten Fehlerabschnitt (F1) des Unterwasserstromkabels (1) zu bestimmen.

13. Fehlerlokalisierungssystem (10) nach Anspruch 12, wobei das Fehlerlokalisierungssystem (10) ferner Folgendes umfasst:
- ein Glasfaserkabel (61), das dazu konfiguriert ist, sich entlang des ersten Fehlerabschnitts (F1) des Unterwasserstromkabels (1) zu befinden;
- einen Generator (62) für optische Signale zum Senden eines optischen Signals in das Glasfaserkabel (61);
- eine Analysevorrichtung (63) für optische Signale zum Analysieren eines optischen Reflexionssignals, das sich aus dem optischen Signal ergibt, das von dem Glasfaserkabel (61) während eines Zeitraums reflektiert wird, in dem ein elektrisches Impulssignal von der Impulserzeugungsvorrichtung (20) erzeugt wird;
wobei die Analysevorrichtung (63) für optische Signale dazu konfiguriert ist, den Ort des Fehlers als einen zweiten Fehlerabschnitt (F2) des Unterwasserstromkabels (1) zu bestimmen.

14. Verfahren zur Lokalisierung eines Fehlers in einem Unterwasserstromkabel (1), wobei das Verfahren die folgenden Schritte umfasst:
- Laden eines Stromkabels (25) mit Strom aus einem Hochspannungs-Gleichstrom-Generator (22);
- Entladen des Stroms des Stromkabels (25) als elektrisches Impulssignal in das Unterwasserstromkabel (1);
- Bestimmen der Lokalisierung des Fehlers durch Analysieren eines Reflexionssignals, das sich aus dem elektrischen Impulssignal ergibt, das von dem Unterwasserstromkabel (1) reflektiert wird.

15. Verfahren nach Anspruch 14, wobei der Schritt des Bestimmens der Lokalisierung des Fehlers das Bestimmen der Lokalisierung des Fehlers als einen ersten Fehlerabschnitt (F1) des Unterwasserstromkabels (1) umfasst.

16. Verfahren nach Anspruch 15, wobei das Verfahren ferner die folgenden Schritte umfasst:
- Lokalisieren eines Glasfaserkabels (61) entlang des ersten Fehlerabschnitts (F1) des Unterwasserstromkabels (1);
- Senden eines optischen Signals in das Glasfaserkabel (61);
- Bestimmen des Position des Fehlers als einen zweiten Fehlerabschnitt (F2) des Unterwasserstromkabels (1) durch Analysieren eines optischen Reflexionssignals, das sich aus dem optischen Signal ergibt, das von dem Glasfaserkabel (61) während eines Zeitraums reflektiert wird, in dem ein elektrisches Impulssignal von dem Stromkabel (25) abgegeben wird.

## Revendications

1. Système de localisation de défaut (10) pour localiser un défaut dans un câble d'alimentation sous-marin (1), dans lequel le système de localisation de défaut (10) comprend :
- un dispositif de génération d'impulsions (20) destiné à générer un signal d'impulsion électrique ;
- un dispositif d'analyse de signal (30) configuré pour déterminer la localisation du défaut en analysant un signal de réflexion résultant du fait que le signal d'impulsion électrique soit réfléchi par le câble d'alimentation sous-marin (1) ;
dans lequel le dispositif de génération d'impulsions (20) comprend un générateur de signal (22), une première borne de sortie (21a) et une seconde borne de sortie (21b), dans lequel la première borne de sortie (21a) peut être connectée à un conducteur (1a) du câble d'alimentation sous-marin (1) et dans lequel la seconde borne (21b) peut être connectée à un écran (1c) du câble d'alimentation sous-marin (1) ;
dans lequel :
- le générateur de signal (22) est un générateur CC HT (22) ;
**caractérisé en ce que** :
le dispositif de génération d'impulsions (20) comprend en outre :
- un câble d'alimentation (25) connecté entre le générateur de signal (22) et l'une des bornes de sortie (21a, 21b) ;
- un interrupteur (28) ;
- un circuit de commande (29) destiné à commander l'interrupteur (28) ;
dans lequel le câble d'alimentation (25) a une première extrémité (25F) et une seconde extrémité (25S) et comprend un conducteur (25a), un système d'isolation (25b) à l'extérieur du conducteur (25a) et un écran (25c) à l'extérieur du système d'isolation (25b) ;
dans lequel le générateur CC HT (22) est connecté entre le conducteur (25a) de la première extrémité (25F) du câble d'alimentation (25) et l'écran (25c) du câble d'alimentation (25) ;
dans lequel le conducteur (25a) de la seconde extrémité (25S) du câble d'alimentation (25) est connecté à la première borne de sortie (21a) ;
dans lequel l'écran (25c) du câble d'alimentation (25) est connecté à la seconde borne de sortie (21b) ;
dans lequel le circuit de commande (29) est configuré pour :
- ouvrir l'interrupteur (28) afin de charger le câble d'alimentation (25) avec l'alimentation provenant du générateur CC HT (22) ;
- fermer l'interrupteur (28) afin de décharger l'alimentation du câble d'alimentation (25) dans le câble d'alimentation sous-marin (1).

2. Système de localisation de défaut (10) selon la revendication 1, dans lequel le générateur CC HT (22) est connecté entre le conducteur (25a) de la première extrémité (25F) du câble d'alimentation (25) et l'écran (25c) de la première extrémité (25F) du câble d'alimentation (25).

3. Système de localisation de défaut (10) selon la revendication 1 ou 2, dans lequel l'écran (25c) de la première extrémité (25F) du câble d'alimentation (25) est connecté à la seconde borne de sortie (21b) et/ou dans lequel l'écran (25c) de la seconde extrémité (25S) du câble d'alimentation (25) est connecté à la seconde borne de sortie (21b).

4. Système de localisation de défaut (10) selon l'une quelconque des revendications précédentes, dans lequel le circuit de commande (29) est configuré pour fermer l'interrupteur (28) une fois que le câble d'alimentation (25) a été chargé avec l'alimentation provenant du générateur CC HT (22).

5. Système de localisation de défaut (10) selon l'une quelconque des revendications précédentes, dans lequel le câble d'alimentation (25) :
- est un câble CA ou CC de moyenne tension ou un câble CA ou CC de haute tension ; et/ou
- a une longueur de 50 à 150 m.

6. Système de localisation de défaut (10) selon l'une quelconque des revendications précédentes, dans lequel le câble d'alimentation (25) est enroulé en une bobine.

7. Système de localisation de défaut (10) selon l'une quelconque des revendications précédentes, dans lequel l'interrupteur (28) est connecté entre le conducteur (25a) de la seconde extrémité (25S) du câble d'alimentation (25) et la première borne de sortie (21a).

8. Système de localisation de défaut (10) selon l'une quelconque des revendications 1 à 6 précédentes, dans lequel le dispositif de génération d'impulsions (20) comprend :
- un câble d'alimentation supplémentaire (26) connecté entre le générateur de signal (22) et l'une des bornes de sortie (21a, 21b) ;
dans lequel le câble d'alimentation supplémentaire (26) a une première extrémité (26F) et une seconde extrémité (26S) et comprend un conducteur (26a), un système d'isolation (26b) à l'extérieur du conducteur (26a) et un écran (26c) à l'extérieur du système d'isolation (26b) ;
dans lequel le conducteur (26a) du câble d'alimentation supplémentaire (26) est connecté au conducteur (25a) de la seconde extrémité (25S) du câble d'alimentation (25) ;
dans lequel l'écran (26c) du câble d'alimentation supplémentaire (26) est connecté à la première borne de sortie (21a).

9. Système de localisation de défaut (10) selon la revendication 8, dans lequel l'interrupteur (28) est connecté entre le conducteur (25) de la première extrémité (25F) du câble d'alimentation (25) et l'écran (25c) de la première extrémité (25F) du câble d'alimentation (25).

10. Système de localisation de défaut (10) selon la revendication 8 ou 9, dans lequel le câble d'alimentation supplémentaire (26) :
- est un câble CA ou CC de moyenne tension ou un câble CA ou CC de haute tension ; et/ou
- a une longueur de 50 à 150 m.

11. Système de localisation de défaut (10) selon l'une quelconque des revendications précédentes, dans lequel le dispositif d'analyse de signal (30) comprend un séparateur de haute tension (31).

12. Système de localisation de défaut (10) selon l'une quelconque des revendications précédentes,
dans lequel le dispositif d'analyse de signal (30) est configuré pour déterminer la localisation du défaut en tant que première section de défaut (F1) du câble d'alimentation sous-marin (1).

13. Système de localisation de défaut (10) selon la revendication 12, dans lequel le système de localisation de défaut (10) comprend en outre :
- un câble à fibre optique (61) configuré pour être situé le long de la première section de défaut (F1) du câble d'alimentation sous-marin (1) ;
- un générateur de signal optique (62) destiné à envoyer un signal optique dans le câble à fibre optique (61) ;
- un dispositif d'analyse de signal optique (63) destiné à analyser un signal de réflexion optique résultant du fait que le signal optique soit réfléchi par le câble à fibre optique (61) pendant une période au cours de laquelle un signal d'impulsion électrique est généré par le dispositif de génération d'impulsions (20) ;
dans lequel le dispositif d'analyse de signal optique (63) est configuré pour déterminer la localisation du défaut en tant que seconde section de défaut (F2) du câble d'alimentation sous-marin (1).

14. Procédé de localisation d'un défaut dans un câble d'alimentation sous-marin (1), dans lequel le procédé comprend les étapes de :
- charge d'un câble d'alimentation (25) avec une alimentation provenant d'un générateur CC HT (22) ;
- décharge de l'alimentation du câble d'alimentation (25) sous forme de signal d'impulsion électrique dans le câble d'alimentation sous-marin (1) ;
- détermination de la localisation du défaut en analysant un signal de réflexion résultant du fait que le signal d'impulsion électrique soit réfléchi par le câble d'alimentation sous-marin (1).

15. Procédé selon la revendication 14, dans lequel l'étape de détermination de la localisation du défaut comprend la détermination de la localisation du défaut en tant que première section de défaut (F1) du câble d'alimentation sous-marin (1).

16. Procédé selon la revendication 15, dans lequel le procédé comprend en outre l'étape de :
- localisation d'un câble à fibre optique (61) le long de la première section de défaut (F1) du câble d'alimentation sous-marin (1) ;
- envoi d'un signal optique dans le câble à fibre optique (61) ;
- détermination de la localisation du défaut en tant que seconde section de défaut (F2) du câble d'alimentation sous-marin (1) en analysant un signal de réflexion optique résultant du fait que le signal optique soit réfléchi par le câble à fibre optique (61) pendant une période au cours de laquelle un signal d'impulsion électrique est déchargé du câble d'alimentation (25).
